# EUROPÄISCHE PATENTSCHRIFT

(11) **EP 3 201 941 B1**
(45) Veröffentlichungstag und Bekanntmachung des Hinweises auf die Patenterteilung: **21.12.2022**
(21) Anmeldenummer: 15767167.8
(22) Anmeldetag: 24.09.2015
(51) Int. Cl.: H01L 21/02, H01L 21/304

(54) **KOMBINIERTES WAFERHERSTELLUNGSVERFAHREN MIT EINER LÖCHER AUFWEISENDEN AUFNAHMESCHICHT**
COMBINED WAFER PRODUCTION METHOD WITH A RECEIVING LAYER HAVING HOLES
PROCÉDÉ COMBINÉ DE FABRICATION DE TRANCHES AU MOYEN D'UNE COUCHE RÉCEPTRICE POURVUE DE TROUS

(30) Priorität: 29.09.2014 DE 102014014422
(43) Veröffentlichungstag der Anmeldung: 09.08.2017
(73) Patentinhaber: Siltectra GmbH, 01099 Dresden (DE)
(72) Erfinder: RICHTER, Jan, 01109 Dresden (DE); BEYER, Christian, 09599 Freiberg (DE); AJAJ, Anas, 94513 Schönberg (DE)
(74) Vertreter: Müller Hoffmann & Partner
(86) Internationale Anmeldenummer: PCT/EP2015/071948
(87) Internationale Veröffentlichungsnummer: WO 2016/050596

(56) Entgegenhaltungen:
- DE-A1-102012 001 620
- US-A1- 2005 178 495
- US-A1- 2008 020 547
- US-A1- 2011 259 936
- US-A1- 2012 171 866
- US-B1- 6 214 733

## Beschreibung

Die vorliegende Erfindung bezieht sich auf ein Verfahren zum Herstellen von Festkörperschichten.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht.

Die Druckschrift US 2005 / 0 178 495 A1 beschreibt den Transfer von Halbleiterelementen von einem Spendersubstrat zu einem Zielsubstrat. Eine Ionenimplantation bildet in dem Spendersubstrat eine Ablöseebene zwischen einer Bauteilschicht und einem Hauptteil des Spendersubstrats aus. In der Bauteilschicht werden Halbleiterelemente ausgebildet. Ein Transfersubstrat (handle substrate) aus einem Glaswerkstoff wird auf die Bauteilschicht aufgeklebt. Die Bauteilschicht wird entlang der Ablöseebene vom Hauptteil des Spendersubstrats abgelöst und auf ein Zielsubstrat übertragen. Die Klebung zwischen Bauteilschicht und Transfersubstrat wird geschwächt und anschließend das Transfersubstrat entlang der geschwächten Klebung von der Bauteilschicht abgezogen. Die Druckschrift US 2012 / 0 171 866 A1 beschreibt das Übertragen von auf einem GaAs Substrat ausgebildeten GaAs Elementen auf ein Zielsubstrat. Ein Trockenschichtphotoresist (dry film resist) wird auf die Oberfläche das GaAs Substrats mit den GaAs Elementen aufgebracht, belichtet und entwickelt, so dass Abschnitte des Trockenschichtphotoresists über den Lücken zwischen den GaAs Elementen entfernt werden. Die Druckschrift US 2008 / 0 020 547 A1 bezieht sich auf den Transfer von Objekten in Mikrometer- oder Millimetergröße von einem Ausgangssubstrat auf ein Zielsubstrat mittels eines Transfersubstrats, das auf Polydimethylsiloxan (PDMS) basiert. Die Objekte werden auf dem Ausgangssubstrat ausgebildet und durch mechanisches Sägen lateral getrennt. Eine Mischung aus einem unvernetzten Polymer und einem Aushärtemittel wird in flüssiger Form aufgetragen und zu PDMS ausgehärtet. Das ausgehärtete PDMS füllt die Lücken zwischen den Objekten und bildet oberhalb der Objekte eine durchgehende Schicht. Das Ausgangssubstrat wird von der Rückseite her bis zur PDMS Kante gedünnt. Die Objekte sind damit in das Transfersubstrat eingebettet und können durch molekulares Bonden einzeln auf das Zielsubstrat übertragen werden, wobei sie sich automatisch aus dem Transfersubstrat lösen können. Die Druckschrift US 6 214 733 B1 bezieht sich auf ein Verfahren zur Handhabung dünner Halbleiterelemente. Die Halbleiterelemente werden auf einer Vorderseite eines Halbleitersubstrats ausgebildet. Ein Polymer wird abgeschieden. Das Polymer füllt Zwischenräume zwischen den Halbleiterelementen und deckt die Halbleiterelemente ab. An der freiliegenden Oberfläche wird das Polymer mit einem Saphirträger verbunden. Das Halbleitersubstrat wird bis zur Schichtdicke der Halbleiterelemente gedünnt. Anschließend werden die Halbleiterelemente auf ein neues Substrat übertragen, der Saphirträger abgenommen und Reste des Polymers chemisch aufgelöst.

Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafer mit weniger Materialaufwand und damit effizienter und kostengünstiger herzustellen. Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Die Druckschriften DE102012001620 A1 und US2011259936 A1 beschreiben ein Verfahren zum Ausbilden dünner Siliziumscheiben. Auf Vorder- und Rückseite einer dicken Siliziumscheibe wird jeweils eine dünne Schicht aus PDMS aufgebracht. In einer der PDMS Schichten wird der thermische Ausdehnungskoeffizient lokal variiert. Beispielsweise wird das PDMS Material lokal entfernt oder in die betreffende PDMS Schicht wird lokal ein Fremdstoff eingebettet, z.B. Glasperlen, Luftblasen, Metallpartikel oder Fasern. Danach wird die dicke Siliziumscheibe zusammen mit den PDMS Schichten stark abgekühlt. Die dabei auftretenden thermomechanischen Spannungen spalten entlang einer Trennfläche, die im Wesentlichen parallel zu den Grenzflächen zwischen der Siliziumscheibe und den PDMS Schichten verläuft, eine dünne Siliziumscheibe von der dicken Siliziumscheibe ab. Der Abstand der Trennfläche zur gegenüberliegenden Oberfläche der abgespaltenen, dünnen Siliziumscheibe variiert lokal entsprechend dem Muster des thermischen Ausdehnungskoeffizienten in der PDMS Schicht mit dem lokal eingebrachten Fremdstoff.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Ferner dauert das Ablösen der Polymerschicht von dem abgespalteten Wafer sehr lange, da beim Ablösen eine Flüssigkeit in den Zwischenraum von Folien und Wafer gelangen muss, wodurch die Polymerschicht sehr lange nicht zum Abtrennen eines weiteren Wafers verwendet werden kann.

Es ist somit die Aufgabe der vorliegenden Erfindung ein Verfahren zur Herstellung von Festkörperschichten bereitzustellen, das die kostengünstige und schnelle Herstellung von Festkörperplatten bzw. Wafern mit einer gleichmäßigen Dicke ermöglicht, insbesondere mit einem TTV von weniger als 120 Mikrometer.

Die zuvor genannte Aufgabe wird durch den Gegenstand der unabhängigen Ansprüche gelöst, die die vorliegende Erfindung definieren. Ausführungsformen, die nicht unter den Gegenstand der Ansprüche fallen, sind nicht Teil der vorliegenden Erfindung.

Ein Verfahren umfasst dabei mindestens die Schritte, Bereitstellen eines Festkörpers zum Abtrennen mindestens einer Festkörperschicht, Fixieren einer Aufnahmeschicht zum Halten der Festkörperschicht an dem Festkörper, wobei die Aufnahmeschicht eine Vielzahl an Löcher zum Leiten einer Flüssigkeit aufweist, wobei die Aufnahmeschicht mittels einer Verbindungsschicht an dem Festkörper fixiert wird und thermisches Beaufschlagen der Aufnahmeschicht zum, insbesondere mechanischen, Erzeugen von Spannungen in dem Festkörper, wobei sich durch die Spannungen ein Riss in dem Festkörper entlang einer Ablöseebene ausbreitet, wobei durch den Riss die Festkörperschicht von dem Festkörper abgetrennt wird.

Diese Lösung ist vorteilhaft, da durch die Löcher in der Aufnahmeschicht das Fluid zum Schwächen oder Zersetzen oder Auflösen der Verbindungsschicht sehr viel einfacher bzw. schneller bzw. in größeren Mengen an die Verbindungschicht heranführbar ist. In anderen Worten ist somit gemäß einer weiteren bevorzugten Ausführungsform der vorliegenden Erfindung zum Ablösen der Aufnahmeschicht von dem Festkörper ein Fluid, insbesondere eine Flüssigkeit, durch die Löcher der Verbindungsschicht zuführbar, wobei das Fluid bewirkt, dass die Fixierung der Aufnahmeschicht an dem Festkörper geschwächt oder aufgehoben wird.

Die Löcher weisen gemäß der vorliegenden Erfindung einen Durchmesser von weniger als 0,1mm auf. Diese Ausführungsform ist vorteilhaft, da je kleiner die Löcher in der Aufnahmeschicht bzw. in der Folie sind, desto homogener bzw. ebener erfolgt eine Rissführung im Inneren des Festkörpers.

Die Aufnahmeschicht weist gemäß einer weiteren bevorzugten Ausführungsform der vorliegenden Erfindung mehr als 10 Löcher, bevorzugt mehr als 100 Löcher und besonders bevorzugt mehr als 1000 Löcher auf. Diese Ausführungsform ist vorteilhaft, da die Aufnahmeschicht bzw. Folie z.B. in bestimmten Regionen eine größere Löcheranzahl als in anderen Regionen aufweisen kann, wodurch in der Region mit der größeren Löcheranzahl bevorzugt mehr Flüssigkeit in der gleichen Zeit durch die Aufnahmeschicht hindurchleitbar ist. Bevorzugt weist die Aufnahmeschicht Flächenanteile auf, die je cm² mehr als 1, 2, 3, 4, oder 5 Löcher, insbesondere mehr als 10 Löcher, insbesondere mehr als 50 Löcher, insbesondere mehre als 100 Löcher aufweist. Ferner ist denkbar, dass die Löcher in bestimmten Abschnitten der Aufnahmeschicht oder über die gesamte Aufnahmeschicht homogen verteilt sind.

In einem Radius von weniger als 50mm, bevorzugt weniger als 25mm und besonders bevorzugt weniger als 5mm, 4mm, 3mm, 2mm, 1mm oder 0,5mm, um das Zentrum eines jeden Loches herum ist gemäß einer weiteren bevorzugten Ausführungsform der vorliegenden Erfindung mindestens ein weiteres Loch ausgebildet. Diese Ausführungsform ist vorteilhaft, da durch diese Anordnung eine äußerst definierte und schnelle Fluidleitung durch die Aufnahmeschicht hindurch möglich ist.

Mittels mindestens einem Femtosekunden-Laser (fs-Laser), werden vor oder nach der Anbringung der Aufnahmeschicht an dem Festkörper Defekte in der inneren Struktur des Festkörpers zum Vorgeben der Ablöseebene erzeugt.

Diese Lösung ist vorteilhaft, da aufgrund der Strahlungsquelle die Ablöseschicht bzw. Defektschicht in dem Festkörper erzeugbar ist, durch die der Riss bei der Rissausbreitung geleitet bzw. geführt wird, was die Realisierung sehr kleiner TTVs, insbesondere kleiner als 200 Mikrometer oder 100 Mikrometer oder kleiner als 80 Mikrometer oder kleiner als 60 Mikrometer oder kleiner als 40 Mikrometer oder kleiner als 20 Mikrometer oder kleiner als 10 Mikrometer oder kleiner als 5 Mikrometer, insbesondere 4, 3, 2 oder 1 Mikrometer, ermöglicht. Die Strahlenbeaufschlagung des Wafers schafft somit in einem ersten Schritt eine Art Perforation im Inneren des Festkörpers, entlang der in einem zweiten Schritt die Rissausbreitung erfolgt bzw. entlang der die Festkörperschicht von dem Festkörper abgetrennt wird.

Durch die defektbedingte Rissführung wird verhindert, dass die Löcher in der Aufnahmeschicht einen Einfluss auf die Topografie der durch den Riss entstehenden Oberflächenstruktur haben bzw. der Einfluss der Löcher auf die Topografie sehr stark reduziert wird. Durch die Defekte bzw. Laservorschädigung wird nämlich erreicht, dass der Riss ausreichend stabil in der durch die Defekte definierten Rissebene bzw. Risskontur verläuft.

Gemäß einer bevorzugten Ausführungsform der vorliegenden Erfindung hat der Laser eine Pulsdauer unter 500fs.

Die Spannungen zum Ablösen der Festkörperschicht von dem Festkörper werden durch die thermische Beaufschlagung der Aufnahmeschicht erzeugt, wobei die Aufnahmeschicht zumindest einen Polymerwerkstoff aufweist, wobei der Polymerwerkstoff einen Glasübergang bei einer Temperatur kleiner 0°C erfährt. Die thermische Beaufschlagung stellt ein Abkühlen der Aufnahmeschicht bzw Polymerschicht unter 0°C und bevorzugt unter -10°C dar. Die Abkühlung der Polymerschicht erfolgt derart, dass zumindest ein Teil der Polymerschicht, die bevorzugt aus PDMS besteht, einen Glasübergang vollzieht. Die Abkühlung kann hierbei eine Abkühlung auf unter -100°C sein, die z.B. mittels flüssigen Stickstoffs bewirkbar ist. Diese Ausführungsform ist vorteilhaft, da sich die Polymerschicht in Abhängigkeit von der Temperaturveränderung zusammenzieht und/oder einen Glasübergang erfährt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Gemäß einer bevorzugten Ausführungsform der vorliegenden Erfindung wird der Festkörper an einer Halteschicht zum Halten des Festkörpers angeordnet, wobei die Halteschicht an einem ersten ebenen Flächenanteil des Festkörpers angeordnet wird, wobei der erste ebene Flächenanteil des Festkörpers von einem zweiten ebenen Flächenanteil des Festkörpers beabstandet ist, wobei am zweiten ebenen Flächenanteil die Polymerschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da der Festkörper zumindest abschnittweise und bevorzugt vollständig zwischen der Halteschicht und der Polymerschicht angeordnet ist, wodurch mittels einer dieser Schichten oder mittels beider Schichten die Spannungen zur Risserzeugung bzw. Rissausbreitung in den Festkörper einleitbar sind.

Mindestens oder genau eine Strahlungsquelle ist gemäß der vorliegenden Erfindung zum Bereitstellen der in den Festkörper einzubringenden Strahlung derart konfiguriert, dass die von ihr ausgestrahlten Strahlen die Defekte an vorbestimmten Orten innerhalb des Festkörpers erzeugen. Diese Ausführungsform ist vorteilhaft, da mittels einer Strahlungsquelle, insbesondere mittels eines Lasers, äußerst genau Defekte in dem Festkörper erzeugbar sind.

Für das Verfahren ergeben sich insbesondere zwei Anwendungsfälle, im Folgenden "Wafering" und "thinning" genannt. Beim "Wafering" wird das Verfahren üblicherweise dafür genutzt eine dicke Schicht von einem noch dickeren Halbleiterblock abzulösen, typischerweise einen Wafer (mit den industriespezifischen Dicken) von einem Ingot. Beim "Thinning" wird das Verfahren dafür eingesetzt, von einem Wafer eine sehr dünne Schicht abzuspalten, was dem heutigen Prozess des grindings entspricht, allerdings mit dem Vorteil, dass das nicht benötigte Material unversehrt bleibt und wiederverwendet werden kann. Eine klare Trennung von "thinning" und "Wafering" ist kompliziert, weil z.B. das "thinning" auch durch Beaufschlagung von der Rückseite eines Wafers geschehen kann, so dass zwar eine dünne Schicht entsteht, der Laser aber tief in das Material eindringt.

Für den "thinning" Fall :
Die Strahlungsquelle wird gemäß einer weiteren bevorzugten Ausführungsform der vorliegenden Erfindung derart eingestellt, dass die von ihr ausgestrahlten Strahlen zum Erzeugen der Ablöseebene auf eine definierte Tiefe, insbesondere <100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene weniger als 100 Mikrometer und bevorzugt weniger als 50 Mikrometer und besonders bevorzugt weniger als oder gleich 20, 10, 5 oder 2 Mikrometer von der ebenen Oberfläche des Festkörpers beabstandet innerhalb des Festkörpers ausgebildet. Somit wird die Ablöseebene bevorzugt in Form einer aus Defekten erzeugten Ebene ausgebildet, wobei die Defekte weniger als 100 Mikrometer und bevorzugt weniger als 50 Mikrometer und besonders bevorzugt weniger als 20, 10 oder 2 Mikrometer von der ebenen Oberfläche des Festkörpers beabstandet innerhalb des Festkörpers ausgebildet werden.

Für den "wafering" Fall :
Die Strahlungsquelle wird gemäß einer weiteren bevorzugten Ausführungsform der vorliegenden Erfindung derart eingestellt, dass die von ihr ausgestrahlten Strahlen zum Erzeugen der Ablöseebene auf eine definierte Tiefe, insbesondere >100µm, in den Festkörper eindringen. Bevorzugt wird die Ablöseebene parallel beabstandet zu einer äußeren und bevorzugt ebenen Oberfläche des Festkörpers ausgebildet. Bevorzugt ist die Ablöseebene mehr als 100 Mikrometer und bevorzugt mehr als 200 Mikrometer und besonders bevorzugt mehr als 400 oder 700 Mikrometer von der ebenen Oberfläche des Festkörpers beabstandet innerhalb des Festkörpers ausgebildet. Somit wird die Ablöseebene bevorzugt in Form einer aus Defekten erzeugten Ebene ausgebildet, wobei die Defekte mehr als 100 Mikrometer und bevorzugt mehr als 200 Mikrometer und besonders bevorzugt mehr als 400 oder 700 Mikrometer von der ebenen Oberfläche des Festkörpers beabstandet innerhalb des Festkörpers ausgebildet werden.

Der Festkörper wird gemäß einer weiteren bevorzugten Ausführungsform der vorliegenden Erfindung mit einer vorgegebenen Wellenlänge und/oder Leistung beaufschlagt, wobei die vorgegebene Wellenlänge bevorzugtan das jeweilige Material bzw. Substrat angepasst ist. Diese Ausführungsform ist vorteilhaft, da die Defektgröße durch die Wellenlänge und/oder die Leistung beeinflussbar ist.

Der Festkörper weist gemäß einer weiteren bevorzugten Ausführungsform der vorliegenden Erfindung Silizium und/oder Gallium oder Perowskit auf und die Polymerschicht und/oder die Halteschicht bestehen zumindest teilweise und bevorzugt vollständig oder zu mehr als 75% aus Polydimethylsiloxane (PDMS), wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wird, wodurch die Spannungen sehr genau in dem Festkörper erzeugt werden können.

Gemäß einer weiteren bevorzugten Ausführungsform der vorliegenden Erfindung sind die Spannungen in dem Festkörper derart einstellbar bzw. erzeugbar, dass die Rissauslösung und/oder die Rissausbreitung zum Erzeugen einer Topografie der sich in der Rissebene ergebenden Oberfläche steuerbar ist. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topographie der erzeugten bzw. abgetrennten Festkörperschicht vorteilhaft beeinflussbar ist.

Gemäß einer weiteren bevorzugten Ausführungsform der vorliegenden Erfindung geben die Defekte mindestens eine Rissführungsschicht vor, wobei die mindestens eine Rissführungsschicht eine von einer ebenen Gestalt abweichende Gestalt aufweist. Diese Lösung ist vorteilhaft, da die erzeugten Festkörperschichten oder die erzeugten Festkörper eine von einer ebenen Schicht abweichende Gestalt aufweisen können. Es können somit nicht mehr nur ebene Schichten, sondern ebenfalls dreidimensionale Körper aus einem Werkstück mittels einer Rissausbreitung herausgebildet bzw. erzeugt werden. Derart hergestellte Festkörper weisen aufgrund des Herstellungsverfahrens eine sehr vorteilhafte und nur wenig bis nicht nachzubearbeitende Oberfläche auf. So sind z.B. optische Elemente, wie z.B. ein Spat oder eine Linse in einem einstufigen oder mehrstufigen, insbesondere zwei oder dreistufigen, Splitprozess herstellbar.

Die Gestalt der Rissführungsschicht weist somit gemäß einer bevorzugten Ausführungsform der vorliegenden Erfindung zumindest abschnittsweise die Kontur eines dreidimensionalen Objektes, insbesondere einer Linse oder eines Spaten, auf.

Gemäß einer bevorzugten Ausführungsform der vorliegenden Erfindung werden die Defekte mittels einer Defekterzeugungsvorrichtung bzw. der Strahlungsquelle erzeugt, wobei die Defekterzeugungsvorrichtung derart konfiguriert ist, dass die Defekte mit einem konstanten Abstand zur Defekterzeugungsvorrichtung in dem Werkstück erzeugt werden, wobei das Werkstück und die Defekterzeugungsvorrichtung derart relativ zueinander geneigt werden, dass die von der Defekterzeugungsvorrichtung erzeugten Defekte in der Rissführungsschicht erzeugt werden, wobei die Defekterzeugungsvorrichtung und das Werkstück während der Defekterzeugung lediglich zweidimensional zueinander umpositioniert werden. Die Defekterzeugungsvorrichtung wird somit bevorzugt gegenüber dem Werkstück umpositioniert oder das Werkstück wird gegenüber der Defekterzeugungsvorrichtung umpositioniert oder die Defekterzeugungsvorrichtung und das Werkstück werden beide zueinander umpositioniert.

Diese Ausführungsform ist vorteilhaft, da die Strahlungsquelle bzw. die Defekterzeugungseinrichtung zur Defekterzeugung lediglich umpositioniert werden muss und keine Modifikation der Defekterzeugungsvorrichtung bewirkt werden muss, insbesondere keine veränderte Defekteinbringtiefe bestimmt und eingestellt werden muss.

Die Defekte werden gemäß einer weiteren bevorzugten Ausführungsform mittels einer Defekterzeugungsvorrichtung bzw. der Strahlungsquelle erzeugt, wobei die Defekterzeugungsvorrichtung derart konfiguriert ist, dass die Defekte mit einem sich zeitweise veränderndem Abstand zur Defekterzeugungsvorrichtung in dem Werkstück erzeugt werden, wobei in Abhängigkeit von dem Abstand der Defekterzeugungsvorrichtung zu dem zu erzeugenden Defekts zumindest zeitweise eine Modifikation der Defekterzeugungsvorrichtung bewirkt wird, insbesondere eine veränderte Defekteinbringtiefe bestimmt und eingestellt wird. Diese Ausführungsform ist vorteilhaft, da bevorzugt keine Neigungsvorrichtung zum Neigen des Werkstücks vorgesehen werden muss.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7).

Gemäß der vorliegenden Erfindung ist die Strahlungsquelle oder ein Teil der Strahlungsquelle als Femtosekundenlaser (fs-Laser) ausgebildet. Diese Lösung ist vorteilhaft, da durch die Verwendung eines fs-Laser, die vertikale Ausbreitung des gestörten Materials minimiert wird. Es ist durch die Verwendung eines fs-Lasers möglich Defekte in dem Werkstück sehr genau einzubringen bzw. darin zu erzeugen. Die Wellenlänge und/oder die Energie des fs-Laser sind bevorzugt materialabhängig zu wählen.

Gemäß einer weiteren bevorzugten Ausführungsform der vorliegenden Erfindung wird die Energie des fs-Lasers, derart gewählt, dass die Schädigungsausbreitung im Festkörper bzw. im Kristall kleiner als dreimal die Reyleighlänge, bevorzugt kleiner als die Reyleighlänge und besonders bevorzugt kleiner als ein Drittel der Reyleighlänge ist.

Die Wellenlänge des Laserstrahls des fs-Lasers wird gemäß einer weiteren bevorzugten Ausführungsform der vorliegenden Erfindung derart gewählt, dass die Absorption des Festkörpers bzw. des Materials kleiner als 10cm⁻¹ und bevorzugt kleiner als 1cm⁻¹ und besonders bevorzugt kleiner als 0,1cm⁻¹ ist.

Die einzelnen Defekte resultieren gemäß einer weiteren bevorzugten Ausführungsform der vorliegenden Erfindung jeweils aus einer von dem fs-Laser bewirkten multi-photonen Anregung.

Weiterhin ist gemäß einer weiteren bevorzugten Ausführungsform der vorliegenden Erfindung denkbar, dass die Aufnahmeschicht einen weiteren Werkstoff aufweist, der bevorzugt als Beschichtung auf das Polymer aufgebracht ist. Alternativ ist jedoch ebenfalls denkbar, dass das Polymer als Beschichtung auf den weiteren Werkstoff aufgebracht ist.

Gemäß einer weiteren bevorzugten Ausführungsform der vorliegenden Erfindung weist die Beschichtung lokale Schwächungen auf, insbesondere ist die Beschichtung gebrochen, insbesondere um einer durch das Polymer bei der Spannungserzeugung bewirkten Verformung zu folgen.

Die Wärmeleitfähigkeit (W/(m*K)) des weiteren Werkstoffs ist gemäß einer weiteren bevorzugten Ausführungsform der vorliegenden Erfindung mehr als 5 mal größer, bevorzugt mehr als 10 mal größer und besonders bevorzugt mehr als 30, mehr als 100, mehr als 200 oder mehr als 300 mal größer als die des Polymers, wobei der weitere Werkstoff bevorzugt ein Metall oder eine Legierung ist.

Der weitere Werkstoff ist gemäß einer weiteren bevorzugten Ausführungsform der vorliegenden Erfindung in Form von länglichen Elementen, insbesondere Spänen, innerhalb einer von dem Polymer vorgegebenen Schichtstruktur vorgesehen, wobei die Späne bevorzugt derart ausgerichtet sind, dass sich ihrer Längsachsen (bevorzugt zumindest mehrheitlich) geneigt, insbesondere orthogonal, zur Schichterstreckungsrichtung erstreckt. Bevorzugt werden dazu die Späne beim Erzeugen der Aufnahmeschicht in das flüssige Polymer eingebracht und z.B. über eine Magnetbeaufschlagung ausgerichtet.

Die vorliegende Erfindung bezieht sich ferner auf eine wiederverwendbare Folie zur Spannungserzeugung in einem Festkörper, wobei die Folie zumindest einen Polymerwerkstoff, insbesondere PDMS, aufweist, wobei der Polymerwerkstoff einen Glasübergang bei einer Temperatur kleiner als 0°C, insbesondere bei einer Temperatur kleiner -50°C, erfährt. Die Folie weist eine Vielzahl an Löchern zum Leiten einer Flüssigkeit auf, wobei die Löcher jeweils einen Durchmesser von weniger als 0,1mm aufweisen. Weiterhin werden die Gegenstände der Druckschriften WO 2013/113730 A1, PCT/US2008/012140, PCT/EP2009/067539, DE102013016666.7 und DE102014013107.6 genannt.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a: einen schematischen Aufbau zum Erzeugen von Lokal-Spannungen in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Erzeugung von Lokal-Spannungen mittels Strahlung, insbesondere Lichtwellen;
- Fig. 2b: eine zweite schematisch dargestellte Variante zur Erzeugung von Lokal-Spannungen mittels Strahlung, insbesondere mittels Lichtwellen;
- Fig. 3a: eine erfindungsgemäße Aufnahmeschicht;
- Fig. 3b: eine erfindungsgemäße Aufnahmeschicht, die an einem Festkörper angeordnet ist;
- Fig. 3c: eine weitere Aufnahmeschicht, die an einem Festkörper angeordnet ist; Dieses Beispiel stellt jedoch kein Ausführungsbeispiel der beanspruchten Erfindung dar.
- Fig. 3d: eine weitere Aufnahmeschicht, die an einem Festkörper angeordnet ist; und
- Fig. 3e: eine vierte erfindungsgemäße Aufnahmeschicht, die an einem Festkörper angeordnet ist.

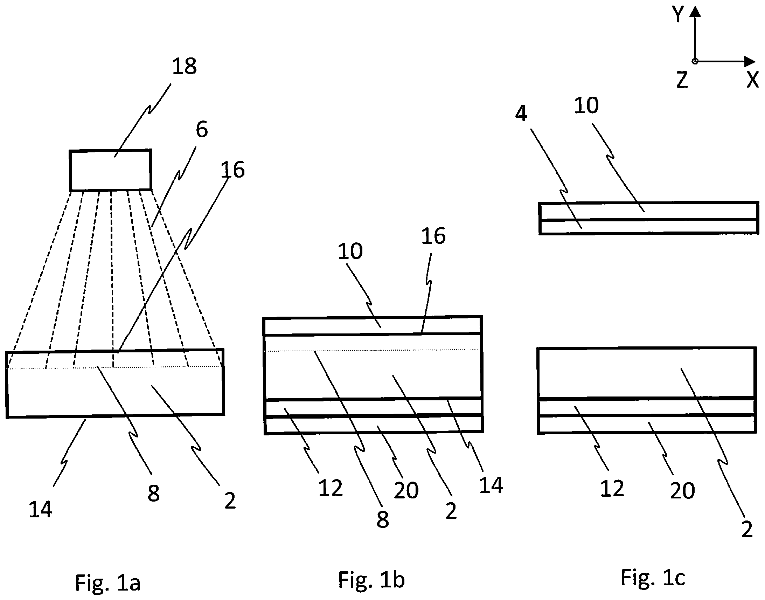

In Fig. 1a ist ein Werkstück 2 bzw. ein Substrat gezeigt, das im Bereich einer Strahlungsquelle 18, insbesondere einem Laser, insbesondere einem Femtosekundenlaser (fs-Laser), angeordnet ist. Das Werkstück 2 weist bevorzugt einen ersten, insbesondere ebenen, Flächenanteil 14 und einen zweiten, insbesondere ebenen, Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt das Werkstück 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 zeitgleich oder zeitversetzt auf das Werkstück 2 ausstrahlt. Die Strahlen 6 dringen je nach Konfiguration definiert tief in das Werkstück 2 ein und erzeugen an der jeweiligen Position bzw. an einer vorbestimmten Position Lokal-Spannungen.

In Fig. 1b ist eine mehrschichtige Anordnung gezeigt, wobei das Werkstück 2 die Rissführungsschicht 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Werkstücks 2 ist bevorzugt eine Polymerschicht 10 angeordnet. Die Aufnahmeschicht bzw. Polymerschicht 10 und/oder die Halteschicht 12 bestehen bevorzugt zumindest teilweise und besonders bevorzugt vollständig aus PDMS und weist besonders bevorzugt eine Vielzahl an Löchern, insbesondere Sacklöcher und/oder Durchgangslöcher, auf.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Werkstücks 2 beabstandet bzw. beabstandbar.

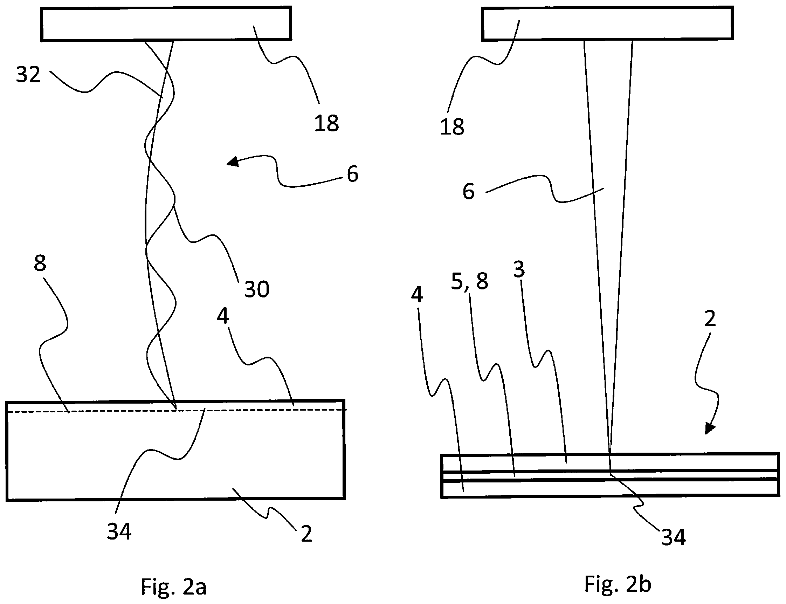

In den Figuren 2a und 2b sind Beispiele für die in Fig. 1a gezeigte Erzeugung einer Rissführungsschicht 8 durch die Einbringung von Lokal-Spannungen in ein Werkstück 2, insbesondere mittels Lichtstrahlen, gezeigt.

Die vorliegende Erfindung bezieht sich somit auf ein Verfahren zum Herstellen von Festkörperschichten, mindestens umfassend die Schritte nach Anspruch 1. Das erfindungsgemäße Verfahren kann dabei zusätzlich einen, mehrere oder alle der nachfolgend angeführten Schritte, insbesondere des Bereitstellens eines Werkstücks 2 zum Abtrennen mindestens einer Festkörperschicht 4, des Erzeugens von bevorzugt definierten Lokal-Spannungen bzw. von lokalen Spannungen mittels mindestens einer Strahlungsquelle, insbesondere einem fs-Laser, in der inneren Struktur des Festkörpers zum Vorgeben einer Rissführungsschicht, entlang der die Festkörperschicht vom Festkörper abgetrennt wird, und des thermischen Beaufschlagens einer an dem Werkstück 2 angeordneten Polymerschicht 10 zum, insbesondere mechanischen, Erzeugen von Ablöse-Spannungen in dem Werkstück 2, wobei sich durch die Ablöse-Spannungen ein Riss in dem Werkstück 2 entlang der Rissführungsschicht 8 ausbreitet, der die Festkörperschicht 4 von dem Werkstück 2 abtrennt, umfassen. Die Lokal-Spannungen bewirken hierbei bevorzugt, dass die Rissausbreitung in der gewünschten Rissführungsschicht 8 erfolgt.

In Fig. 2a ist somit schematisch gezeigt, wie Lokal-Spannungen 34 in einem Werkstück 2, insbesondere zur Erzeugung einer Rissführungsschicht 8 mittels einer Strahlungsquelle 18, im Falle der vorliegenden Erfindung mittels mindestens eines Femtosekundenlasers (fs-Lasers), insbesondere mehrere fs-Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei bevorzugt derart aufeinander abgestimmt bzw. die Distanz zwischen der Strahlungsquelle 18 und der zu erzeugenden Rissführungsschicht 8 ist bevorzugt derart abgestimmt, dass die Wellen 30, 32 im Wesentlichen oder genau auf der Rissführungsschicht 8 in dem Werkstück 2 zusammentreffen, wodurch am Ort des Zusammentreffens 34 infolge der Energien beider Wellen 30, 32 Lokal-Spannungen bzw. Defekte erzeugt werden. Die Erzeugung der Lokal-Spannungen kann dabei durch unterschiedliche oder kombinierte Mechanismen, wie z.B. Sublimation, Aufschmelzen und/oder chemische Reaktion, erfolgen.

In Fig. 2b ist ein fokussierter Lichtstrahl 6 gezeigt, dessen Brennpunkt bevorzugt in der Rissführungsschicht 8 liegt. Es ist hierbei denkbar, dass der Lichtstrahl 6 durch eine oder mehrere fokussierende Körper, insbesondere Linse/n (nicht gezeigt), fokussiert wird. Das Werkstück 2 ist in dieser Ausführungsform mehrschichtig ausgebildet und weist bevorzugt eine teiltransparente oder transparente Substratschicht 3 bzw. Materialschicht auf, die bevorzugt aus Saphir besteht oder Saphir aufweist. Die Lichtstrahlen 6 gelangen durch die Substratschicht 3 auf die Rissführungsschicht 8, die bevorzugt durch eine Opferschicht 5 gebildet wird, wobei die Opferschicht 5 durch die Strahlung derart beaufschlagt wird, dass die Erzeugung von Lokal-Spannungen in der Opferschicht 5 in dem Brennpunkt bzw. im Bereich des Brennpunkts bewirkt wird. Es ist ebenfalls denkbar, dass die Lokal-Spannungen zur Erzeugung der Rissführungsschicht 8 im Bereich oder genau auf einer Grenzfläche zwischen zwei Schichten 3, 4 erzeugt werden. Somit ist ebenfalls denkbar, dass die Festkörperschicht 4 auf einer Trägerschicht, insbesondere einer Substratschicht 3, erzeugt wird und mittels einer oder mehrerer Opferschichten 5 und/oder mittels der Erzeugung von Lokal-Spannungen in einer Grenzfläche, insbesondere zwischen der Festkörperschicht 4 und der Trägerschicht, eine Rissführungsschicht 8 zum Ablösen bzw. Abtrennen der Festkörperschicht 4 erzeugbar ist.

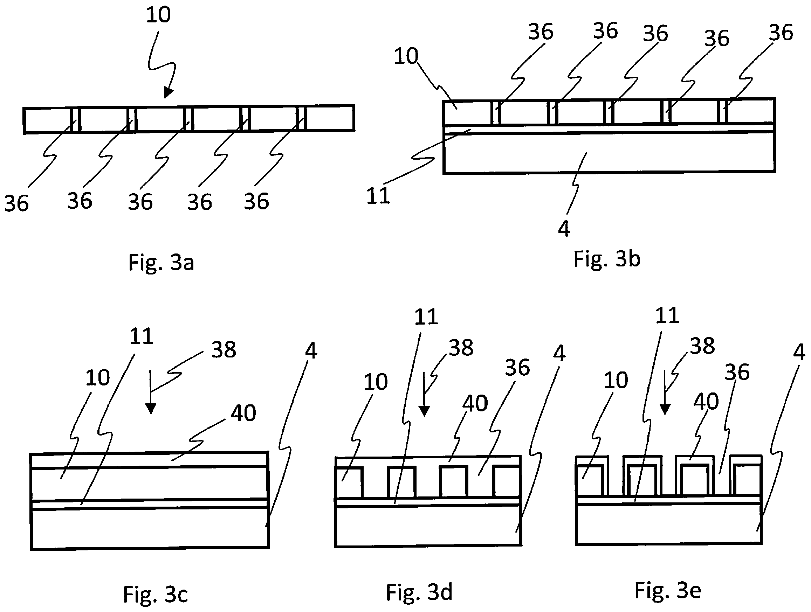

Fig. 3a zeigt eine erfindungsgemäße Aufnahmeschicht 10 bzw. Folie zur Spannungserzeugung in einem Festkörper. Die Folie weist dabei zumindest einen Polymerwerkstoff, insbesondere PDMS, auf, wobei der Polymerwerkstoff einen Glasübergang bei einer Temperatur kleiner als 0°C, insbesondere bei einer Temperatur kleiner -50°C, erfährt.

Die Folie weist eine Vielzahl an Löcher 36 zum Leiten einer Flüssigkeit durch die Folie hindurch auf, wobei die Löcher 36 jeweils einen Durchmesser von weniger als 0,1mm aufweisen.

Fig. 3b zeigt einen Festkörper 2 und eine davon abgetrennte Festkörperschicht 4. An der Festkörperschicht 4 ist noch eine Aufnahmeschicht 10 bzw. eine Folie 10 angeordnet, mittels der die zum Erzeugen eines Risses zum Abtrennen der Festkörperschicht 4 vom Festkörper 2 erforderlichen Spannungen erzeugt wurden. Die Aufnahmeschicht 10 weist eine Vielzahl an Löcher zum Leiten einer Flüssigkeit auf, wobei die Aufnahmeschicht 10 mittels einer Verbindungsschicht 11 an der Festkörperschicht 4 fixiert ist.

Fig. 3c zeigt als ein Beispiel zur Veranschaulichung eine Aufnahmeschicht 10 bzw. Folie, die bevorzugt ebenfalls mittels einer Verbindungsschicht 11 an dem Festkörper 4 anordenbar ist bzw. daran angeordnet ist. Dieses Beispiel stellt jedoch kein Ausführungsbeispiel der beanspruchten Erfindung dar. Die Aufnahmeschicht 10 weist dabei bevorzugt einen ersten Materialanteil 39, insbesondere einen Polymeranteil, und einen zweiten Materialanteil 40, insbesondere einen Metallanteil, auf. Der zweite Materialanteil 40 stellt dabei bevorzugt eine Beschichtung des ersten Materialanteils 39 dar und dient besonders bevorzugt zum beschleunigten Abkühlen des ersten Materialanteils 39. Die Aufnahmeschicht 10 wird dabei bevorzugt aus der Richtung 38 mit Kälte, insbesondere flüssigem Stickstoff, beaufschlagt, wodurch der zweite Materialanteil 40 schnell herunterkühlt und insbesondere durch den unmittelbaren Kontakt mit dem ersten Materialanteil 39 dieser ebenfalls sehr schnell abgekühlt wird.

Fig. 3d zeigt als ein weiteres Beispiel zur Veranschaulichung eine Aufnahmeschicht 10 bzw. Folie, die wiederum durch den ersten Materialanteil 39 und den zweiten Materialanteil 40 gebildet wird. Der erste Materialanteil 39 weist Löcher 36 auf, die durch den zweiten Materialanteil 40 ausgefüllt werden. Bevorzugt beschichtet der zweite Materialanteil 40 den ersten Materialanteil 39 ebenfalls oberseitig, d.h. parallel zur Verbindungsschicht 11.

Fig. 3e zeigt eine weitere Variante der erfindungsgemäßen Aufnahmeschicht 10 bzw. Folie, die wiederum durch den ersten Materialanteil 39 und den zweiten Materialanteil 40 gebildet wird. Der erste Materialanteil 39 weist Löcher 36 auf, die durch den zweiten Materialanteil 40 ausgekleidet werden, d.h. dass die das jeweilige Loch 36 begrenzende Wandung mit dem zweiten Materialanteil beschichtet ist. Bevorzugt beschichtet der zweite Materialanteil 40 den ersten Materialanteil 39 ebenfalls oberseitig, d.h. parallel zur Verbindungsschicht 11.

Ferner ist bevorzugt zusätzlich denkbar, dass das Verfahren zum Herstellen von Festkörperschichten, einen, mehrere oder alle der nachfolgend genannten Schritte umfasst: Bereitstellen eines Festkörpers 2 zum Abtrennen mindestens einer Festkörperschicht 4, Anordnen einer Aufnahmeschicht 10 zum Halten der Festkörperschicht 4 an dem Festkörper 2, wobei die Aufnahmeschicht zumindest aus einem Polymer und einem weiteren Werkstoff besteht, wobei die Aufnahmeschicht bevorzugt volumenmäßig und/oder massemäßig mehrheitlich aus dem Polymer besteht, wobei der weitere Werkstoff eine größere Leitfähigkeit als das Polymer aufweist, thermisches Beaufschlagen der Aufnahmeschicht 10 zum, insbesondere mechanischen, Erzeugen von Spannungen in dem Festkörper 2, wobei sich durch die Spannungen ein Riss in dem Festkörper 2 entlang einer Ablöseebene 8 ausbreitet, wobei durch den Riss die Festkörperschicht 4 von dem Festkörper 2 abgetrennt wird.

Weiterhin weist die erfindungsgemäße Folie zur Spannungserzeugung in einem Festkörper, zumindest einen Polymerwerkstoff, insbesondere PDMS, und einen weiteren Werkstoff auf, wobei die Folie volumenmäßig mehrheitlich aus dem Polymerwerkstoff besteht, wobei der weitere Werkstoff eine größere Wärmeleitfähigkeit als der Polymerwerkstoff aufweist, wobei der Polymerwerkstoff einen Glasübergang bei einer Temperatur kleiner als 0°C, insbesondere bei einer Temperatur kleiner -50°C, erfährt, wobei die Folie eine Vielzahl an Löchern zum Leiten einer Flüssigkeit durch die Folie hindurch aufweist, wobei die Löcher jeweils einen Durchmesser von weniger als 0,1 mm aufweisen.

### Bezugszeichenliste

- 2: Werkstück
- 3: Substrat
- 4: Festkörperschicht
- 5: Opferschicht
- 6: Strahlung
- 8: Rissführungsschicht
- 10: Aufnahmeschicht / Folie
- 11: Verbindungsschicht
- 12: Halteschicht
- 14: erster ebener Flächenanteil
- 16: zweiter ebener Flächenanteil
- 18: Strahlungsquelle/Defekterzeugungsvorrichtung
- 20: Stabilisierungseinrichtung
- 36: Loch
- 38: Beaufschlagung mit Kälte
- 39: erster Materialanteil
- 40: zweiter Materialanteil

- X: erste Richtung
- Y: zweite Richtung
- Z: dritte Richtung

## Patentansprüche

1. Verfahren zum Herstellen von Festkörperschichten, mindestens umfassend die Schritte:
Bereitstellen eines Festkörpers (2) zum Abtrennen mindestens einer Festkörperschicht (4);
Fixieren einer Aufnahmeschicht (10) zum Halten der Festkörperschicht (4) an dem Festkörper (2), wobei die Aufnahmeschicht (10) mittels einer Verbindungsschicht (11) an dem Festkörper (2) fixiert wird, wobei die Aufnahmeschicht (10) zumindest einen Polymerwerkstoff aufweist, wobei der Polymerwerkstoff einen Glasübergang bei einer Temperatur kleiner als 0°C erfährt, und wobei die Aufnahmeschicht (10) eine Vielzahl an Löchern (36) mit einem Durchmesser von weniger als 0,1mm zum Leiten eines Fluids durch die Aufnahmeschicht (10) an die Verbindungsschicht (11) aufweist;
Erzeugen von Defekten in der inneren Struktur des Festkörpers (2) zum Vorgeben einer Ablöseebene (8) mittels mindestens eines Femtosekunden-Lasers (18) vor oder nach dem Fixieren der
Aufnahmeschicht (10) an dem Festkörper (2); und
thermisches Beaufschlagen der Aufnahmeschicht (10) zum Erzeugen von Spannungen in dem Festkörper (2), wobei sich durch die Spannungen ein Riss in dem Festkörper (2) entlang der Ablöseebene (8) ausbreitet, wobei durch den Riss die Festkörperschicht (4) von dem Festkörper (2) abgetrennt wird.

2. Verfahren nach Anspruch 1,
wobei
die Aufnahmeschicht mehr als 10 Löcher (36), bevorzugt mehr als 100 Löcher (36) und besonders bevorzugt mehr als 1000 Löcher (36), aufweist.

3. Verfahren nach einem der vorangegangenen Ansprüche,
wobei
in einem Radius von weniger als 50mm, bevorzugt weniger als 25mm und besonders bevorzugt weniger als 5mm, um das Zentrum eines jeden Loches herum mindestens ein weiteres Loch ausgebildet ist.

4. Verfahren nach einem der vorangegangenen Ansprüche,
wobei
zum Ablösen der Aufnahmeschicht (10) von der Festkörperschicht (4) ein Fluid, insbesondere eine Flüssigkeit, durch die Löcher der Verbindungsschicht (11) zugeführt wird, wobei das Fluid bewirkt, dass die Fixierung der Aufnahmeschicht (10) an die Festkörperschicht (4) geschwächt oder aufgehoben wird.

5. Verfahren nach Anspruch 4,
wobei
der Femtosekunden-Laser (18) derart eingestellt wird, dass die von ihm ausgestrahlten Strahlen (6) zum Erzeugen der Ablöseebene (8) auf eine definierte Tiefe von weniger als 200 µm, bevorzugt von weniger als 100µm und weiter bevorzugt von weniger als 50µm und besonders bevorzugt von weniger als 20µm, in den Festkörper (2) eindringen.

6. Verfahren nach Anspruch 4,
wobei
der Femtosekunden-Laser (18) derart eingestellt wird, dass die von ihm ausgestrahlten Strahlen (6) zum Erzeugen der Ablöseebene (8) auf eine definierte Tiefe von mehr als 100 µm, bevorzugt von mehr als 200 µm und weiter bevorzugt von mehr als 400 µm und besonders bevorzugt von mehr als 700µm, in den Festkörper (2) eindringen.

7. Verfahren nach einem der vorangegangenen Ansprüche 4 bis 6,
wobei
der Femtosekunden-Laser (18) eine Pulsdauer von unter 500 fs hat.

8. Verfahren nach einem der vorangegangenen Ansprüche 4 bis 7,
wobei
die Energie des Laserstrahls des Femtosekunden-Lasers derart gewählt wird, dass die Schädigungsausbreitung im Festkörper (2) kleiner als 3 mal die Rayleighlänge, bevorzugt kleiner als die Rayleighlänge und besonders bevorzugt kleiner ein Drittel mal die Rayleighänge, ist.

9. Verfahren nach einem der vorangegangenen Ansprüche 4 bis 8,
wobei
die Wellenlänge des Laserstrahls des Femtosekunden-Lasers derart gewählt wird, dass die Absorption des Festkörpers (2) kleiner als 10cm⁻¹ und bevorzugt kleiner als 1cm⁻¹ und besonders bevorzugt kleiner als 0,1cm⁻¹, ist.

10. Verfahren nach einem der vorangegangenen Ansprüche 4 bis 9,
wobei
sich die einzelnen Defekte jeweils in Folge einer von dem Femtosekunden-Laser, bewirkten multi-photonen Anregung ergeben.

11. Anordnung mit einer Aufnahmeschicht (10), aufweisend:
einen Festkörper (2) mit einer durch Defekte in der inneren Struktur des Festkörpers (2) vorgegebenen Ablöseebene (8), wobei die Defekte mittels mindestens eines Femtosekunden-Lasers (18) vor oder nach dem Fixieren der Aufnahmeschicht (10) an dem Festkörper (2) erzeugt wurden;
eine Verbindungsschicht (11) auf einer Oberfläche des Festkörpers (2),
die durch die Verbindungsschicht (11) an dem Festkörper (2) fixierte Aufnahmeschicht (10) auf der Verbindungsschicht (11), wobei die Aufnahmeschicht (10) zumindest einen Polymerwerkstoff aufweist, wobei der Polymerwerkstoff einen Glasübergang bei einer Temperatur kleiner als 0°C erfährt, thermisches Beaufschlagen der Aufnahmeschicht (10) zum Erzeugen von Spannungen in dem Festkörper (2) führt, wobei sich durch die Spannungen ein Riss in dem Festkörper (2) entlang der Ablöseebene (8) ausbreitet, wobei durch den Riss die Festkörperschicht (4) von dem Festkörper (2) abgetrennt wird, und wobei die Aufnahmeschicht (10) eine Vielzahl an Löchern (36) mit einem Durchmesser von weniger als 0,1mm zum Leiten eines Fluids an die Verbindungsschicht (11) aufweist.

12. Wiederverwendbare Folie zur Spannungserzeugung in einem Festkörper,
wobei die Folie zumindest einen Polymerwerkstoff, insbesondere PDMS, aufweist, wobei der Polymerwerkstoff einen Glasübergang bei einer Temperatur kleiner als 0°C, insbesondere bei einer Temperatur kleiner -50°C, erfährt,
**dadurch gekennzeichnet, dass**
die Folie eine Vielzahl an Löchern zum Leiten einer Flüssigkeit durch die Folie hindurch aufweist, wobei die Löcher jeweils einen Durchmesser von weniger als 0,1mm aufweisen.

13. Verwendung einer Folie gemäß Anspruch 12 als Aufnahmeschicht in einem Verfahren nach Anspruch 1.

## Claims

1. Method for producing solid-state layers,
at least comprising the steps of:
providing a solid-state body (2) for the separation of at least one solid-state layer (4);
fastening a receiving layer (10) for holding the solid-state layer (4) on the solid-state body (2), the receiving layer (10) being fastened on the solid-state body (2) by means of a connecting layer (11), the receiving layer (10) comprising at least one polymer material, the polymer material undergoing a glass transition at a temperature of less than 0°C, and the receiving layer (10) having a multiplicity of holes (36) having a diameter of less than 0.1 mm for conducting a fluid through the receiving layer (10) to the connecting layer (11);
generating defects in the internal structure of the solid-state body (2) for predefining a detachment plane (8) by means of at least one femtosecond laser (18) before or after the fastening of the receiving layer (10) on the solid-state body (2); and
acting thermally on the receiving layer (10) for the generation of stresses in the solid-state body (2), the stresses causing a crack to propagate in the solid-state body (2) along the detachment plane (8), and the crack causing the solid-state layer (4) to separate from the solid-state body (2).

2. Method according to Claim 1,
wherein
the receiving layer has more than 10 holes (36), preferably more than 100 holes (36) and more preferably more than 1000 holes (36).

3. Method according to any of the preceding claims,
wherein
in a radius of less than 50 mm, preferably less than 25 mm and more preferably less than 5 mm, around the centre of each hole there is at least one further hole.

4. Method according to any of the preceding claims,
wherein
for detaching the receiving layer (10) from the solid-state layer (4), a fluid, more particularly a liquid, is supplied through the holes in the connecting layer (11), the effect of the fluid being that the fastening of the receiving layer (10) to the solid-state layer (4) is weakened or undone.

5. Method according to Claim 4,
wherein
the femtosecond laser (18) is adjusted in such a way that the rays (6) it emits for generating the detachment plane (8) penetrate the solid-state body (2) to a defined depth of less than 200 µm, preferably of less than 100 µm and more preferably of less than 50 µm, and especially preferably of less than 20 µm.

6. Method according to Claim 4,
wherein
the femtosecond laser (18) is adjusted in such a way that the rays (6) it emits for generating the detachment plane (8) penetrate the solid-state body (2) to a defined depth of more than 100 µm, preferably of more than 200 µm and more preferably of more than 400 µm, and especially preferably of more than 700 µm.

7. Method according to any of preceding Claims 4 to 6,
wherein
the femtosecond laser (18) has a pulse duration of less than 500 fs.

8. Method according to any of preceding Claims 4 to 7,
wherein
the energy of the laser beam of the femtosecond laser is selected such that the damage propagation in the solid-state body (2) is less than 3 times the Rayleigh length, preferably less than the Rayleigh length and more preferably less than one-third times the Rayleigh length.

9. Method according to any of preceding Claims 4 to 8,
wherein
the wavelength of the laser beam of the femtosecond laser is selected such that the absorption of the solid-state body (2) is less than 10 cm⁻¹ and preferably less than 1 cm⁻¹ and more preferably less than 0.1 cm⁻¹.

10. Method according to any of preceding Claims 4 to 9,
wherein
the individual defects arise in each case as a consequence of a multi-photon excitation brought about by the femtosecond laser.

11. Arrangement having a receiving layer (10), comprising:
a solid-state body (2) having a detachment plane (8) predefined by defects in the internal structure of the solid-state body (2), the defects having been generated by means of at least one femtosecond laser (18) before or after the fastening of the receiving layer (10) on the solid-state body (2);
a connecting layer (11) on a surface of the solid-state body (2),
the receiving layer (10) on the connecting layer (11), fastened by the connecting layer (11) on the solid-state body (2), the receiving layer (10) comprising at least one polymer material, the polymer material undergoing a glass transition at a temperature of less than 0°C, acting thermally on the receiving layer (10) leading to the generation of stresses in the solid-state body (2), the stresses causing a crack to propagate in the solid-state body (2) along the detachment plane (8), the crack causing the solid-state layer (4) to separate from the solid-state body (2), and the receiving layer (10) having a multiplicity of holes (36) having a diameter of less than 0.1 mm for conducting a fluid to the connecting layer (11).

12. Reusable sheet for generating stresses in a solid-state body,
the sheet comprising at least one polymer material, more particularly PDMS, and the polymer material undergoing a glass transition at a temperature of less than 0°C, more particularly at a temperature of less than -50°C,
**characterized in that**
the sheet has a multiplicity of holes for guiding a liquid through the sheet, the holes each having a diameter of less than 0.1 mm.

13. Use of a sheet according to Claim 12 as a receiving layer in a method according to Claim 1.

## Revendications

1. Procédé de fabrication de couches de corps solide, comprenant au moins les stades :
on se procure un corps (2) solide pour la séparation d'au moins une couche (4) de corps solide ;
on fixe une couche (10) de réception pour le maintien de la couche (4) de corps solide sur le corps (2) solide, dans lequel on fixe la couche (10) de réception sur le corps (2) solide au moyen d'une couche (11) de liaison, dans lequel la couche (10) de réception a au moins un matériau polymère, le matériau polymère subissant une transition à l'état vitreux à une température plus basse que 0°C et la couche (10) de réception ayant une pluralité de trous (36) d'un diamètre de moins de 0,1 mm pour envoyer un fluide à la couche (11) de liaison à travers la couche (10) de réception ;
on produit des défauts dans la structure intérieure du corps (2) solide pour la prescription d'un plan (8) de détachement au moyen d'au moins un laser (18) à femtoseconde avant ou après la fixation de la couche (10) de réception au corps (2) solide ;et on sollicite thermiquement la couche (10) de réception pour la production de tensions dans le corps (2) solide, dans lequel par les tensions une fissure dans le corps (2) solide se propage le long du plan (8) de détachement, dans lequel par la fissure on sépare la couche (4) de corps solide du corps (2) solide.

2. Procédé suivant la revendication 1,
dans lequel
la couche de réception a plus de 10 trous (36), de préférence plus de 100 trous (36) et, d'une manière particulièrement préférée, plus de 1000 trous (36).

3. Procédé suivant l'une des revendications précédentes,
dans lequel
au moins un autre trou est constitué autour du centre d'un trou dans un rayon de moins de 50 mm, de préférence de moins de 25 mm et, d'une manière particulièrement préférée, de moins de 5 mm.

4. Procédé suivant l'une des revendications précédentes,
dans lequel
pour détacher la couche (10) de réception du corps (4) solide on envoie un fluide, notamment un liquide dans les trous de la couche (11) de liaison, dans lequel le fluide fait que la fixation de la couche (10) de réception à la couche (4) de corps solide est affaiblie ou supprimée.

5. Procédé suivant la revendication 4,
dans lequel
on règle le laser (18) à femtoseconde de manière à ce que le rayonnement (6) qu'il émet pour la production du plan (8) de détachement pénètre à une profondeur définie de moins de 200 µm, de préférence de moins de 100 µm et, d'une manière particulièrement préférée, de moins de 50 µm et, d'une manière encore plus particulièrement préférée, de moins de 20 µm, dans le corps (2) solide.

6. Procédé suivant la revendication 4,
dans lequel
on règle le laser (18) à femtoseconde de manière à ce que le rayonnement (6) qu'il émet pour produire le plan (8) de détachement pénètre dans le corps (2) solide à une profondeur définie de plus de 100 µm, de préférence de plus de 200 µm et, d'une manière encore plus préférée, de plus de 400 µm et, d'une manière particulièrement préférée, de plus de 700 µm.

7. Procédé suivant l'une des revendications 4 à 6,
dans lequel
le laser (18) à femtoseconde a une durée de pulsation de moins de 500 fs.

8. Procédé suivant l'une des revendications précédentes 4 à 7,
dans lequel
on choisit l'énergie du faisceau laser à femtoseconde de manière à ce que la propagation d'un dommage dans le corps (2) solide soit plus petite que trois fois la longueur de Rayleigh, de préférence plus petite que la longueur de Rayleigh et, d'une manière particulièrement préférée, plus petite qu'un tiers de la longueur de Rayleigh.

9. Procédé suivant l'une des revendications 4 à 8 précédentes,
dans lequel
on choisit la longueur d'onde du faisceau du laser à femtoseconde de manière à ce que l'absorption du corps (2) solide soit plus petite que 10cm⁻¹ et, d'une manière préférée, plus petite que 1cm⁻¹ et, d'une manière particulièrement préférée, plus petite que 0,1cm⁻¹.

10. Procédé suivant l'une des revendications 4 à 9 précédentes,
dans lequel
les divers défauts se produisent respectivement à la suite d'une excitation multiphotonique provoquée par le laser à femtoseconde.

11. Montage ayant une couche (10) de réception, comportant :
un corps (2) solide ayant un plan (8) de détachement prescrit par des défauts dans la structure intérieure du corps (2) solide, dans lequel les défauts ont été produits au moyen d'au moins un laser (18) à femtoseconde avant ou après la fixation de la couche (10) de réception sur le corps (2) solide ;
une couche (11) de liaison sur une surface du corps (2) solide, la couche (10) de réception sur la couche (11) de liaison étant fixée au corps (2) solide par la couche (11) de liaison, la couche (10) de réception ayant au moins un matériau polymère, le matériau polymère subissant une transition d'état vitreux à une température plus basse que 0°C, une sollicitation thermique de la couche (10) de réception conduisant à la production de tensions dans le corps (2) solide, dans lequel par les tensions une fissure se propage dans le corps (2) solide le long du plan (8) de détachement, dans lequel par la fissure la couche (4) de corps solide est séparée du corps (2) solide et dans lequel la couche (10) de réception a une pluralité de trous (36) d'un diamètre de moins de 0,1 mm pour envoyer un fluide à la couche (11) de liaison.

12. Feuille réutilisable de production de tensions dans un corps solide,
dans laquelle la feuille a au moins un matériau polymère, notamment du PDMS, le matériau polymère subissant une transition à l'état vitreux à une température plus basse que 0°C, notamment à une température plus basse que - 50°C,
**caractérisée en ce que**
la feuille a une pluralité de trous pour le passage d'un liquide à travers la feuille, les trous ayant chacun un diamètre de moins de 0,1 mm.

13. Utilisation d'une feuille suivant la revendication 12 comme couche de réception dans un procédé suivant la revendication 1.
